# EUROPÄISCHE PATENTSCHRIFT

(11) **EP 0 462 304 B1**
(45) Veröffentlichungstag und Bekanntmachung des Hinweises auf die Patenterteilung: **12.04.1995**
(21) Anmeldenummer: 90111680.6
(22) Anmeldetag: 20.06.1990
(51) Int. Cl.: H03L 5/00

(54) **Schaltungsanordnung zur Regelung der Amplituden eines Oszillators**
Arrangement for the amplitude regulation of an oscillator
Montage de réglage en amplitude d'un oscillateur

(43) Veröffentlichungstag der Anmeldung: 27.12.1991
(73) Patentinhaber: SIEMENS AKTIENGESELLSCHAFT, 80333 München (DE)
(72) Erfinder: Fenk, Josef, Dipl.-Ing., D-8057 Eching/Ottenburg (DE)

(56) Entgegenhaltungen:
- EP-A- 0 299 464
- DE-A- 2 803 430
- Patent Abstacts of Japan, vol 005, Nr.192 (E085) and JP-A-56114404

## Beschreibung

Die Erfindung betrifft eine Schaltungsanordnung zum Regeln der Amplitude des Ausgangssignals eines Oszillators mit den Merkmalen:
- der Emitter eines ersten Oszillatortransistors ist über eine steuerbare Stromquelle mit einem Anschluß für ein Versorgungspotential (Masse) verbunden,
- der Oszillator enthält mindestens ein frequenzbestimmendes Element, das an den Basisanschluß des ersten Oszillatortransistors angeschlossen ist,
- der Emitteranschluß des ersten Oszillatortransistors ist über einen Regelverstärker auf einen Steuereingang der steuerbaren Stromquelle rückgekoppelt.

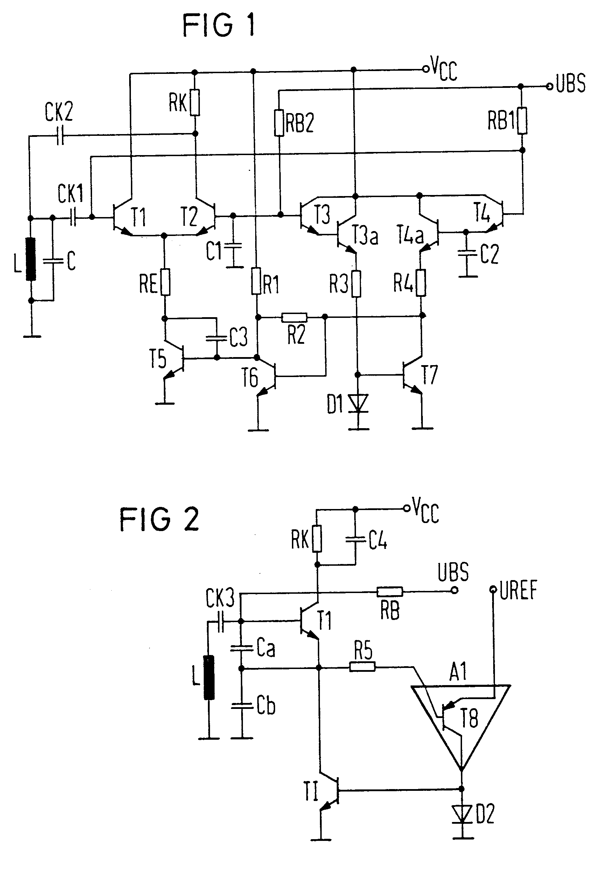

Die Erfindung ist unter anderem anwendbar für Oszillatoren mit Abstimmdioden im frequenzbestimmenden Resonanzkreis. Solche Oszillatoren haben aufgrund einer relativ großen Güteänderung über der Frequenz üblicherweise einen Amplitudengang von ca. 10 db bis 15 db, falls die Amplitude des Oszillatorverstärkers nicht geregelt ist. Wird für einen Oszillatorverstärker mit einer vorgegebenen Frequenzbandbreite der dem Oszillatorverstärker eingeprägte Strom derart eingestellt, daß der Oszillator am unteren Bandende eine ausreichende Schwingsicherheit aufweist, so hat man dadurch am oberen Bandende eine zu große Schwingamplitude. Diese kann sich störend auf das Abstrahlverhalten auswirken. Ist ein solcher Oszillatorverstärker monolithisch integriert, so können an den Außenanschlüssen dieses Oszillatorverstärkers, an denen beispielsweise der Schwingkreis angekoppelt wird, störend große Amplituden auftreten. Außerdem können, falls die Oszillator-Transistoren in einem Teil des Frequenzbandes des Oszillators im Sättigungsbetrieb arbeiten, Substratströme fließen, die sich störend auswirken können. Figur 1 zeigt das Prinzipschaltbild einer Oszillatorschaltung, bei der eine Schaltungsanordnung zur Amplitudenregelung des Oszillator-Ausgangssignales realisiert ist. Eine solche Oszillatorschaltung kann beispielsweise dem kommerziell erhältlichen integrierten Schaltkreis TDA5230 entnommen werden. Figur 1 zeigt einen ersten und einen zweiten Oszillator-Transistor T1 und T2, deren Emitteranschlüsse miteinander zusammengeschaltet sind. Der Basisanschluß des zweiten Transistors T2 ist mit dem Basisanschluß eines dritten Transistors T3 zusammengeschaltet. Der Basisanschluß des ersten Transistors T1 ist mit dem Basisanschluß eines vierten Transistors T4 zusammengeschaltet. Der Emitteranschluß des dritten Transistors T3 ist an den Basisanschluß eines weiteren Transistors T3a geschaltet, der Emitteranschluß des vierten Transistors T4 ist an den Basisanschluß eines weiteren Transistors T4a geschaltet. Die Kollektoranschlüsse der Transistoren T3, T3a, T4 und T4a sind gemeinsam an ein erstes Versorgungspotential V_{CC} geschaltet, so daß der Transistor T3 mit dem Transistor T3a sowie der Transistor T4 mit dem Transistor T4a von der Funktionsweise her jeweils wie ein Transistor mit hoher Stromverstärkung angesehen werden kann. Die Basisanschlüsse des ersten und des vierten Transistors T1 und T4 sind über einen sog. Bias-Widerstand RB1 an ein sogenanntes Bias-Potential UBS geschaltet und die Basisanschlüsse der Transistoren T2 und T3 sind über einen weiteren Bias-Widerstand RB2 ebenfalls an das Bias-Potential UBS geschaltet. Durch dieses Bias-Potential UBS und diese Bias-Widerstände RB1, RB2 sind die Arbeitspunkte der Transistoren T1, T2, T3, T3a, T4 und T4a in Abhängigkeit vom eingeprägten Emitterstrom einstellbar. Der Basisanschluß des ersten Transistors T1 ist über eine Koppelkapazität CK1 und der Kollektoranschluß des zweiten Transistors T2 über eine weitere Koppelkapazität CK2 an einen Anschluß eines durch die Kapazität C und die Induktivität L realisierten Parallel-Schwingkreises angeschlossen, und der andere Anschluß dieses Parallel-Schwingkreises ist an ein Bezugspotential Masse geschaltet. Der Kollektoranschluß des zweiten Transistors T2 ist über einen Kollektorwiderstand RK an das erste Versorgungspotential V_{CC} geschaltet. Der Kollektoranschluß des ersten Transistors T1 ist in Figur 1 unmittelbar an dieses erste Versorgungspotential V_{CC} geschaltet, es ist jedoch auch möglich, zwischen den Kollektoranschluß des ersten Transistors und das erste Versorgungspotential V_{CC} einen oder mehrere pn-Übergänge vorzusehen. Der Basisanschluß des zweiten Transistors T2 und somit auch der des dritten Transistors T3 sind über eine Kapazität C1 wechselspannungsmäßig gegen Bezugspotential Masse geschaltet. Die Emitteranschlüsse des ersten und des zweiten Transistors T1 und T2 sind über einen Widerstand RE an den Kollektoranschluß eines Transistors T5 angeschlossen, dessen Emitteranschluß gegen Bezugspotential Masse geschaltet ist. Eine in Figur 1 zwischen den Kollektoranschluß des Transistors T5 und den Basisanschluß dieses Transistors T5 geschaltete Kapazität C3 ist für die Funktionsweise der Schaltung erforderlich, kann jedoch bedarfsweise bereits durch die Miller-Kapazität dieses Transistors T5 realisiert sein. Der Transistor T5 bildet zusammen mit dem Widerstand RE eine steuerbare Stromquelle. Der Basisanschluß des Transistors T5 ist mit dem Kollektoranschluß eines Transistors T6 zusammengeschaltet, dessen Emitteranschluß an Bezugspotential Masse geschaltet ist. Der Kollektoranschluß dieses Transistors T6 ist über einen Widerstand R1 an das erste Versorgungspotential V_{CC} geschaltet und über einen Widerstand R2 an den Basisanschluß des Widerstandes T6 geschaltet. Der Transistor T6 wirkt in der in Figur 1 gezeigten Schaltung als Invertierer. Der Basisanschluß des Transistors T6 ist mit dem Kollektoranschluß eines Transistors T7 verbunden, dessen Emitteranschluß gegen Bezugspotential Masse geschaltet ist. Der Basisanschluß dieses Transistors T7 ist mit der Anode einer Diode D1 zusammengeschaltet, deren Katode an Bezugspotential geschaltet ist. Die Diode D1 wirkt mit dem Transistor T7 als Stromspiegelschaltung. Der Basisanschluß des Transistors T7 ist außerdem über einen Widerstand R3 mit dem Emitteranschluß des Transistors T3a verbunden, der Kollektoranschluß des Transistors T7 ist außerdem über einen Widerstand R4 mit dem Emitteranschluß des Transistors T4a verbunden. Der Emitteranschluß des Transistors T4 ist über eine Kapazität C2 an das Bezugspotential Masse geschaltet und ist somit wechselspannungsmäßig mit Masse verbunden. Die aus den Transistoren T3,T3a,T4,T4a und T7 sowie der Diode D1 bestehende Schaltungsanordnung bildet einen Regelverstärker. Hierbei ist der Transistor T4 als Emitterfolger geschaltet und wirkt als Spitzenwertgleichrichter. Das von dieser Schaltungsanordnung gelieferte Steuersignal am Basisanschluß des als Invertierer arbeitenden Transistors T6 steht in unmittelbarem Zusammenhang mit der am Basisanschluß des ersten Transistors T1 bereitgestellten Signalamplitude des Wechselspannungssignales. Die Amplitude des Ausgangssignales der Oszillatorschaltung, die aus den Oszillatortransistoren T1 und T2 und der durch den Widerstand RE und den Transistor T5 realisierten Stromquelle gebildet wird, ist einerseits abhängig von dem am Basisanschluß des ersten Transistors T1 anstehenden Ansteuersignal, andererseits auch von dem durch die Stromquelle T5,RE eingeprägten Strom. Mit steigendem Ansteuersignal am Basisanschluß des Transistors T1 steigt bei Schaltungen nach Figur 1 das von dem Spitzenwertgleichrichter T4 bereitgestellte Signal, so daß durch Zwischenschaltung eines Invertierers T6 der Strom der steuerbaren Stromquelle RE,T5 begrenzt wird.

Bei solchen beschriebenen Schaltungen ist unbedingt erforderlich, daß der Basisanschluß des Transistors T2 und der des Transistors T3 wechselsignalmäßig über eine Kapazität C1 an Bezugspotential Masse geschaltet sind. Deshalb kann mit solchen Verstärkerschaltungen kein Oszillator mit symmetrischer Ansteuerung der Transistoren T1 und T2 betrieben werden. Ist der Basisanschluß des Transistors T2 nämlich nicht wechselsignalmäßig auf Bezugspotential Masse geschaltet, so kann die Gleichrichterschaltung aus den Transistoren T3 und T4 keine signalabhängige Differenzspannung liefern. Außerdem ist bei Schaltungsanordnungen nach Figur 1 im Gleichrichter eine zusätzliche Kapazität C2 erforderlich.

Bei einer Schaltungsanordnung nach Figur 1 sind zusätzliche Elemente, nämlich der Regler bzw. Gleichrichter, an für das Hochfrequenzsignal kritischen Stellen der Oszillatorverstärkerschaltung, hier am Basisanschluß des Oszillatortransistors T1, angeschlossen. Diese zusätzlichen Elemente bringen zusätzliche parasitäre Kapazitäten mit sich, die die obere Grenzfrequenz einer solchen Oszillatorschaltung beeinflussen.

Eine andere Realisierungsform einer amplitudenregelbaren Oszillator-Verstärker-Schaltung ist in der EP 0 299 464 A1 gezeigt. Insbesondere Figur 1 dieser Offenlegungsschrift zeigt eine Oszillator-Verstärker-Schaltung, wie sie im obengenannten Stand der Technik beschrieben ist. Allerdings wird der als Gleichrichter wirkende Regelverstärker nicht an die Basisanschlüsse der Oszillatortransistoren T1 und T2 angeschlossen, sondern an den Kollektoranschluß des zweiten Transistors T2. Auch bei Schaltungen nach der EP 0 299 464 A1 wird in Abhängigkeit vom Wechselsignal des Oszillatorverstärkers über eine Reglerschaltung der Emitterstrom der Oszillator-Verstärker-Schaltung beeinflußt. Bei einer solchen, aus der EP 0 299 464 A1 bekannten Schaltung ist es zwar möglich, den Oszillatorverstärker symmetrisch angesteuert zu betreiben, jedoch sind auch bei solchen Schaltungen zusätzliche Elemente, wie z.B. der Regler, an für das Wechselsignal kritischen Punkten, hier am Kollektoranschluß des Oszillatortransistors T2, angeschlossen. Auch hier wirken sich die zusätzlichen parasitären Kapazitäten negativ auf die obere Grenzfrequenz eines solchen Oszillators aus. Außerdem ist auch bei Schaltungsanordnungen nach der EP 0 299 464 A1 ein Regler in Form eines Spitzenwertgleichrichters mit zusätzlicher Kapazität erforderlich.

In der Veröffentlichung Patent Abstracts of Japan, Band 5, Nr. 192 (E-085), ist eine Schaltungsanordnung zur Stabilisierung des Ausgangspegels eines Oszillators gezeigt, bei der der Emitter eines Transistors, an dessen Basis ein Reihenschwingkreis angeschlossen ist, über eine gesteuerte Stromquelle mit Masse verbunden ist. Die gesteuerte Stromquelle wird über einen vom Emitteranschluß gesteuerten Regelverstärker eingestellt.

Der Erfindung liegt die Aufgabe zugrunde, eine Schaltungsanordnung zur Amplitudenregelung eines Oszillatorverstärkers bereitzustellen, bei der kritische Punkt für das Wechselspannungsverhalten der Oszillatorschaltung nicht durch zusätzliche parasitäre Elemente belastet werden.

Diese Aufgabe wird bei einer Schaltungsanordnung nach dem Oberbegriff des Anspruchs 1 dadurch gelöst daß ein zweiter Oszillatortransistor vorgesehen ist, dessen Emitteranschluß mit dem Emitteranschluß des ersten Oszillatortransistors gekoppelt ist und dessen Kollektoranschluß mit dem frequenzbestimmenden Element des Oszillators verbunden ist, und daß die aus einer Amplitudenänderung des am Basisanschluß mindestens eines der Oszillatortransistoren anliegenden Signals resultierende Gleichspannungsänderung am Emitteranschluß der Oszillatortransistoren als Steuergröße für den Strom der steuerbaren Stromquelle verwendet wird.

Günstige Ausgestaltungsformen sind Gegenstand von Unteransprüchen.

Wesentlich für erfindungsgemäße Schaltungsanordnung zur Amplitudenregelung ist, daß bei Oszillatorverstärkern mit einem durch eine steuerbare Stromquelle eingeprägten Emitterstrom als Steuergröße für diese steuerbare Stromquelle die relative Veränderung des Spannungspegels am Emitteranschluß des Oszillatortransistors T1 herangezogen wird. Dadurch ist kein zusätzlicher Spitzenwertgleichrichter erforderlich, der eine Steuergröße in Abhängigkeit von der Signalamplitude am Basisanschluß des Oszillatortransistors T1 bereitstellt. Infolge des Gleichrichtereffektes der Basisemitterdiode des Oszillatortransistors T1 ändert sich die Spannung am Emitteranschluß des Oszillatortransistors relativ zum Gleichsignalanteil der Spannung am Basisanschluß des Oszillatortransistors in Abhängigkeit von der Amplitude des Wechselsignales am Basisanschluß des Oszillatortransistors. Das gleiche gilt auch, wenn mehr als ein Oszillatortransistor T1 vorgesehen ist.

Ein wesentlicher Vorteil erfindungsgemäßer Schaltungsanordnungen ist, daß zum Herleiten der Steuergröße für die Amplitudenregelung keine zusätzlichen Schaltungselemente und somit keine zusätzlichen parasitären Kapazitäten im Bereich des Kollektors und der Basis von Oszillatortransistoren erforderlich sind.

Im folgenden wird die Erfindung anhand von in den Figuren 2, 3 und 4 gezeigten Ausführungsbeispielen näher erläutert.

Es zeigt:
- Figur 2: in Form eines Prinzipschaltbildes ein besonders einfaches Ausführungsbeispiel der Oszillatorschaltung zur Regelung der Ausgangssignalamplitude;
- Figur 3: ein besonders günstiges Ausführungsbeispiel einer Oszillatorschaltung zur Regelung der Ausgangssignalamplitude;
- Figur 4: ein besonders günstiges Ausführungsbeispiel zur Realisierung eines in Figur 3 in Form eines Prinzipschaltbildes gezeigten Schaltungsteiles S1.

Figur 2 zeigt einen Oszillatortransistor T1, dessen Basisanschluß über eine Induktivität L an ein Versorgungspotential, hier das Bezugspotential Masse geschaltet ist, dessen Basisanschluß außerdem über eine Kapazität Ca an seinen Emitteranschluß angeschlossen ist und außerdem über einen zur Arbeitspunkteinstellung erforderlichen Bias-Widerstand RB an ein Bias-Potential UBS angeschlossen ist. Zwischen dem Basisanschluß des Oszillatortransistors T1 und der Induktivität L ist hierbei ein Koppelkondensator CK3 vorgesehen, der diesen Basisanschluß gleichspannungsmäßig gegen Masse entkoppelt. Der Kollektoranschluß des Oszillatortransistors T1 ist über einen Widerstand RK an ein erstes Versorgungspotential V_{CC} geschaltet und außerdem wechselstrommäßig über eine Kapazität C4 an dieses erstes Versorgungspotential V_{CC} angeschlossen. Der Emitteranschluß des Oszillatortransistors T1 ist über eine Kapazität Cb an Bezugspotential Masse geschaltet, mit dem Kollektoranschluß eines Transistors TI zusammengeschaltet und außerdem über einen Widerstand R5 an einen Eingang eines Reglerverstärkers A1 angeschlossen. Der andere Eingang dieses Reglerverstärkers A1 ist mit einem Referenzpotential UREF beaufschlagt. Der Ausgangsanschluß dieses Reglerverstärkers A1 ist mit dem Katodenanschluß einer Diode D2 verbunden, deren Anodenanschluß an Bezugspotential Masse geschaltet ist. Außerdem ist der Ausgangsanschluß des Reglerverstärkers A1 mit dem Basisanschluß des Transistors TI verbunden. Der Emitteranschluß des Transistors TI ist an Bezugspotential Masse geschaltet. Als besonders einfaches Ausführungsbeispiel eines Reglerverstärkers A1 ist ein pnp-Transistor T8 gezeigt, dessen Basisanschluß den einen Eingang des Reglerverstärkers bildet, dessen Emitteranschluß den anderen Eingang des Reglerverstärkers bildet und dessen Kollektoranschluß den Ausgang des Reglerverstärkers bildet. Die Induktivität L bildet mit der Serienschaltung aus den Kapazitäten Ca und Cb einen Parallelschwingkreis. Dieser Parallelschwingkreis bestimmt die Frequenz eines Signales, das aufgrund der vom Emitteranschluß des Transistors T1 über die Kapazität Ca an den Basisanschluß dieses Transistors T1 bewirkten Rückkopplung angeregt wird und am Basisanschluß dieses Transistors T1 der zur Arbeitspunkteinstellung erforderlichen Gleichspannung überlagert wird. Die Gleichspannung, die am Basisanschluß des Transistors T1 ansteht, bewirkt eine um eine Diodendurchgangsspannung niedrigere Gleichspannung am Emitteranschluß dieses Transistors T1. Das Wechselsignal, das der Gleichspannung am Basisanschluß des Transistors T1 überlagert ist, bewirkt aufgrund der durch entsprechende Dimensionierung der Kapazität Cb erreichten integrierenden Wirkung eine zusätzliche Gleichspannung, die der bei fehlendem Wechselsignal am Basisanschluß des Oszillatortransistors T1 an seinem Emitteranschluß anstehenden Gleichspannung überlagert wird. Diese zusätzliche Gleichspannung ist direkt abhängig von der Amplitude des Wechselsignales am Basisanschluß des Oszillatortransistors T1.

Die Ausgangsgröße des Reglerverstärker A1 wird in Abhängigkeit von der Änderung des Gleichspannungspegels am Emitteranschluß des ersten Transistors T1 im Verhältnis zum Referenzpotential UREF variert. Das Referenzpotential UREF sollte in einem festen Zusammenhang mit dem zur Arbeitspunkteinstellung des Oszillatortransistors T1 am Basisanschluß dieses Oszillatortransistors T1 anstehenden Gleichspannungspegel stehen. Nur dann ist einer Änderung der Amplitude des Wechselsignales am Basisanschluß des Oszillatortransistors T1 eine Änderung der Gleichspannung am Emitteranschluß dieses Oszillatortransistors T1 fest zuordenbar. Wenn der Gleichspannungspegel am Basisanschluß des Oszillatortransistors T1 durch eine Bias-Schaltung auf einem festen Potential gehalten wird, genügt es, wenn das Referenzpotential UREF ebenfalls fest ist. Bei der in Figur 2 gezeigten Prinzipschaltung prägt der Reglerverstärker A1 der Stromspiegelschaltung, gebildet aus dem Transistor T1 und der Diode D2 einen festen Strom ein.

Da das Signal des Oszillators nach Figur 2 einerseits durch den eingeprägten Emitterstrom des Transistors T1 und andererseits durch das am Basisanschluß dieses Oszillatortransistors T1 anstehende Wechselsignal eingestellt werden kann, wird in der gezeigten Schaltung eine Amplitudenregelung dadurch erzielt, daß bei ansteigender Signalamplitude am Basisanschluß des Oszillatortransistors T1 der Emitterstrom dieses Oszillatortransistors T1 in entsprechendem Maße verkleinert wird.

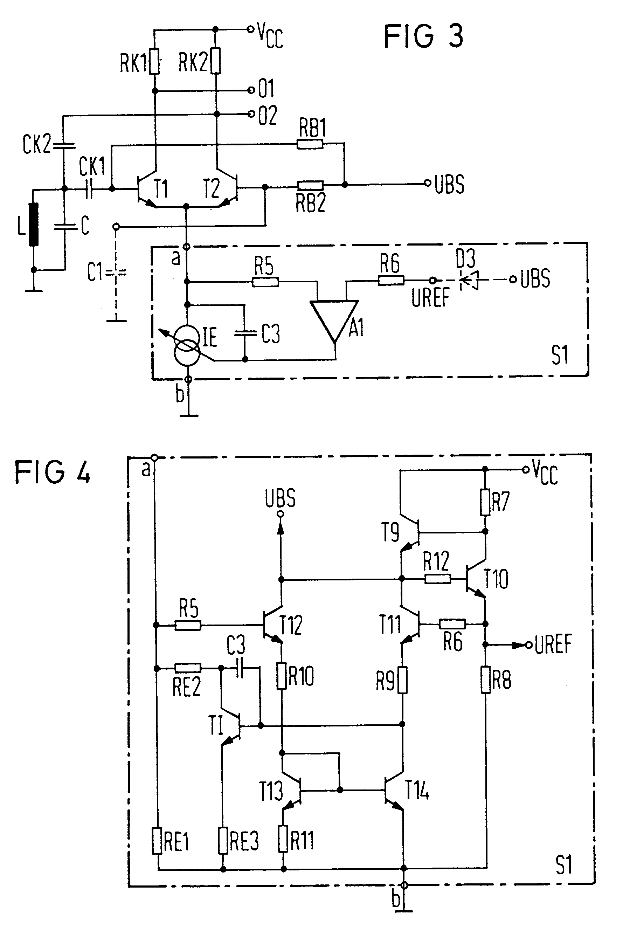

Figur 3 zeigt eine Oszillatorverstärkerschaltung mit einem ersten Oszillatortransistor T1 und einem zweiten Oszillatortransistor T2, deren Emitteranschlüsse miteinander verbunden sind. Der Kollektoranschluß des ersten Oszillatortransistors T1 ist an einer Anschlußklemme 01 angeschlossen und über einen Kollektorwiderstand RK1 an ein erstes Versorgungspotential V_{CC} geschaltet. Der Kollektoranschluß des zweiten Oszillatortransistors T2 ist an eine Anschlußklemme 02 angeschlossen und über einen Kollektorwiderstand RK2 an das erste Versorgungspotential V_{CC} geschaltet. Der Basisanschluß des ersten Oszillatortransistors ist über einen Bias-Widerstand RB1 an ein Bias-Potential UBS angeschlossen. Der Basisanschluß des zweiten Oszillatortransistors T2 ist über einen weiteren Bias-Widerstand RB2 ebenfalls an dieses Bias-Potential UBS angeschlossen. Als frequenzbestimmendes Element zeigt Figur 3 einen Parallelschwingkreis, gebildet aus einer Induktivität L und einer dieser parallel geschalteten Kapazität C, wobei ein Anschluß dieses Parallel-Schwingkreises an Bezugspotential Masse geschaltet ist. Der andere Anschluß dieses Parallelschwingkreises ist einerseits über eine erste Koppelkapazität CK1 an den Basisanschluß des ersten Oszillatortransistors T1 geschaltet und andererseits über eine zweite Koppelkapazität CK2 an die Anschlußklemme 02 und somit an den Kollektoranschluß des zweiten Oszillatortransistors T2 geschaltet. Der Basisanschluß des zweiten Oszillatortransistors T2 ist in Figur 3 über eine unterbrochen dargestellte Kapazität CI an das Bezugspotential geschaltet. Diese Schaltungsvariante wird angewandt, wenn der Oszillatorverstärker unsymmetrisch angesteuert wird. Genauso gut kann der Oszillatorverstärker auch symmetrisch angesteuert werden und hierzu ist ein weiterer Schwingkreis erforderlich, der eine der Induktivität L entsprechende Induktivität und eine der Kapazitäten C entsprechende Kapazität aufweist. Dieser Schwingkreis wäre dann über eine der Koppelkapazität CK1 entsprechende Koppelkapazität an den Basisanschluß des zweiten Oszillatortransistors T2 anzuschalten und außerdem über eine der Koppelkapaziät CK2 entsprechende Kapazität an die Anschlußklemme 01 und somit den Kollektoranschluß des ersten Oszillatortransistors T1 anzuschließen.

Die Emitteranschlüsse der Oszillatortransistoren T1 und T2 sind an einer Anschlußklemme a eines Schaltungsteiles S1 angeschlossen, der mit einer Anschlußklemme b an das Bezugspotential Masse geschaltet ist. Der Schaltungsteil S1 beinhaltet eine steuerbare Stromquelle IE, die zwischen der Anschlußklemme a und der Anschlußklemme b einen Strom einprägt. Der Steuereingang der Stromquelle IE ist mit dem Ausgang eines als Regelverstärker vorgesehenen Differenzverstärkers A1 zusammengeschaltet. Als Differenzverstärker A1 kann hierbei auch ein Operationsverstärker mit Differenzverstärkereingang vorgesehen sein. Zwischen dem Steuereingang der Stromquelle IE und der Anschlußklemme a ist eine Kapazität C3 vorgesehen, die verhindert, daß der mit dem Reglerverstärker A1 realisierte Regler nicht zu Kippschwingungen neigt. Zur Realisierung einer Regelschleife ist ein Signaleingang des Differenzverstärkers A1 über einen Widerstand R5 an die Anschlußklemme a geschaltet. Der andere Signaleingang des Differenzverstärkers A1 ist über einen Widerstand R6 an einen mit einem Referenzpotential UREF beaufschlagten Schaltungsknoten geschaltet. Das Referenzpotential UREF kann hierbei insbesondere derart von dem Bias-Potential UBS abgeleitet sein, daß zwischem dem Bias-Potential UBS und dem das Referenzpotential UREF führenden Schaltungsknoten ein oder mehrere PN-Übergänge beispielsweise in Form einer Diode D3 vorgesehen sind.

Bei dem in Figur 3 dargestellten Oszillator ist für die Oszillatorwirkung der erste Oszillatortransistor T1 in Emitterschaltung betrieben und der zweite Oszillatortransistor T2 in Basisschaltung betrieben. Der Schaltungsteil S1 zeigt eine Regelschaltung mit der Stromquelle IE als Stellglied. Die wirksamen Kapazitäten und Widerstandswerte in dieser Regelschaltung sind vorteilhafterweise so zu wählen, daß die Regelschaltung nicht im Bereich der Sollfrequenz der Oszillatorschaltung wirksam ist. Eine Änderung des Ansteuersignalpegels an den Basisanschlüssen der Oszillatortransistoren T1 und T2 wird über die Basis-Emitter-PN-Übergänge jeweils an den Emitteranschluß und somit die Anschlußklemme a weitergeleitet. Das Potential an der Anschlußklemme a liefert über den Widerstand R5 einen Ist-Wert an einen Signaleingang des als Regelverstärker eingesetzten Differenzverstärkers A1. Dieser Regelverstärker ändert über seinen Signalausgang den zwischen der Anschlußklemme a und der Anschlußklemme b fließenden Strom der Stromquelle IE, bis das Potential an der Anschlußklemme a einem durch das Referenzpotential UREF vorgegebenem Sollwert angepaßt ist.

Figur 4 zeigt ein besonders günstiges Ausführungsbeispiel zur Realisierung eines in Figur 3 in Form eines Prinzipschaltbildes gezeigten Schaltungsteiles S1, wobei die in Figur 4 gezeigte Schaltung außerdem aus einem Versorgungspotential V_{CC} ein Bias-Potential UBS und ein Referenzpotential UREF generiert. Die in Figur 3 mit IE bezeichnete Stromquelle ist in Figur 4 durch drei Stromquellenwiderstände RE1, RE2 und RE3 sowie einen Stromquellentransistor TI realisiert. Hierbei ist zwischen der Anschlußklemme a und der Anschlußklemme b der Widersand RE1 geschaltet. Ein Anschluß des Widerstandes RE2 ist an die Anschlußklemme a geschaltet, der andere Anschluß dieses Widerstandes RE2 ist an den Kollektoranschluß des Stromquellentransistors TI geschaltet und außerdem über eine Kapazität C3 an den Basisanschluß dieses Stromquellentransistors TI angeschlossen. Der Emitteranschluß des Stromquellentransistors TI ist über den Widerstand RE3 an die Anschlußklemme b geschaltet. Die Kapazität C3 in Figur 4 entspricht in ihrer Wirkung der Kapazität C3 in Figur 3. Der Stromquellenwiderstand RE1 legt in Abhängigkeit von der an den Anschlußklemmen a und Anschlußklemmen b anliegenden Spannung den durch die Stromquelle IE fließenden Mindeststrom fest. Dieser Strom kann in Abhängigkeit von der Ansteuerung des Stromquellentransistors TI vergrößert werden, wobei der maximal von der Stromquelle IE zugelassene Strom in Abhängigkeit von der an den Anschlußklemmen a und b anliegenden Spannung durch die Parallelschaltung des Widerstandes RE1 und der Summe der Widerstände RE2 und RE3 festgelegt wird.

Der Kollektoranschluß eines Transistors T9 ist an das Versorgungspotential V_{CC} angeschlossen, der Basisanschluß dieses Transistors T9 ist über einen Widerstand R7 ebenfalls an das Versorgungspotential V_{CC} geschaltet und außerdem mit dem Kollektoranschluß eines Transistors T10 zusammengeschaltet. Der Emitteranschluß des Transistors T9 dient zur Bereitstellung des Bias-Potentiales UBS und ist unter anderem über einen Widerstand R12 mit dem Basisanschluß des Transistors T10 verbunden. Der Emitteranschluß des Transistors T10 dient zur Bereitstellung des Referenzpotentiales UREF und ist über einen Widerstand R8 an das Bezugspotential Masse geschaltet. Sowohl der Transistor T9 als auch der Transistor T10 werden in Emitterfolgerschaltung betrieben. Das Bias-Potential UBS liegt somit um die Basis-Emitterspannung des Transistors T9 unter dem an der Basis dieses Transistors T9 anliegenden Potential. Dieses Potential ist um die aus dem Produkt, aus dem Wert des Widerstandes R7 und der Summe des Basisstromes des Transistors T9 und des Kollektorstromes des Transistors T10 gebildete Spannung kleiner als das Versorgungspotential V_{CC} . Das Referenzpotential UREF liegt um die Basis-Emitterspannung des Transistors T10 unter dem Bias-Potential UBS. Somit ist bei vorgegebenem Versorgungspotential V_{CC} unter Berücksichtigung der Basis-Emitterspannungen der Transistoren T9 und T10 das Bias-Potential UBS durch geeignete Wahl der Widerstandwerte R7 und R8 einstellbar. Ein dem Reglerverstärker A1 in Figur 3 entsprechender Schaltungsteil ist in Figur 4 realisiert durch die Transistoren T11 und T12, deren Kollektoranschlüsse an das Bias-Potential UBS angeschlossen sind.

Der Basisanschluß des Transistors T12 bildet einen Signaleingang des Regelerverstärkers und ist über einen Widerstand R5 an die Anschlußklemme a geschaltet. Der Basisanschluß des Transistors T11 bildet den anderen Reglerverstärkersignaleingang und ist über einen Widerstand R6 an den das Referenzpotential UREF bereitstellenden Schaltungsknoten geschaltet. Der Emitteranschluß des Transistors T11 ist mit einem Anschluß eines Widerstandes R9 verbunden, der andere Anschluß dieses Widerstandes R9 stellt den Signalausgang des Reglerverstärkers dar und ist einerseits mit dem Basisanschluß des Stromquellentransistors TI verbunden und andererseits an den Kollektoranschluß eines Transistors T14 angeschlossen. Der Emitteranschluß des Transistors T14 ist an die Anschlußklemme b und somit an Masse geschaltet. Der Emitteranschluß des Transistors T12 ist über einen Widerstand R10 sowohl an den Kollektoranschluß als auch an den Basisanschluß eines Transistors T13 und ebenso an den Basisanschluß des Transistors T14 geschaltet. Der Emitteranschluß des Transistors T13 ist über einen Widerstand R11 an die Anschlußklemme b geschaltet. Der Transistor T13 und der Transistor T14 bilden zusammen mit dem Widerstand R11 eine Stromspiegelschaltung, die derart mit den Transistoren T11 und T12 zusammenwirkt, daß eine Veränderung des Potentiales an der Anschlußklemme a eine Veränderung des Emitterstromes des Transistors T12 bewirkt, daß dadurch eine Veränderung des Emitterstromes des Transistors T13 und somit auch eine Veränderung des Emitterstromes des Transistors T14 bewirkt wird und daß somit die Ansteuerung des Stromquellentransistors TI in Abhängigkeit von einer Änderung des an der Anschlußklemme a anliegenden Potentiales verändert wird. Die wirksamen Widerstände und die wirksamen Kapazitäten, insbesondere die Kapazität C3 sind hierbei so zu dimensionieren, daß die Regelschaltung nur in einem gewünschten Frequenzbereich wirksam ist.

Die in Figur 4 gezeigten Widerstände RE3 und R11 können auch - einzeln oder zusammen - entfallen. Die Regelverstärkung, die u.a. durch diese Widerstände RE3 und R11 eingestellt werden kann, kann auch dadurch eingestellt werden, daß die Emitterflächen der Transistoren T13 und T14 unterschiedlich groß sind, insbesondere daß die Emitterfläche des Transistors T14 ein Vielfaches der Emitterfläche des Transistors T13 ausmacht.

## Patentansprüche

1. Schaltungsanordnung zum Regeln der Amplitude des Ausgangssignals eines Oszillators mit den Merkmalen:
- der Emitter eines ersten Oszillatortransistors (T1) ist über eine steuerbare Stromquelle (IE) mit einem Anschluß für ein Versorgungspotential (Masse) verbunden,
- der Oszillator enthält mindestens ein frequenzbestimmendes Element (L, C), das an den Basisanschluß des ersten Oszillatortransistors (T1) angeschlossen ist,
- der Emitteranschluß des ersten Oszillatortransistors (T1) ist über einen Regelverstärker (A1) auf einen Steuereingang der steuerbaren Stromquelle (IE) rückgekoppelt,
**dadurch gekennzeichnet,** daß
ein zweiter Oszillatortransistor (T2) vorgesehen ist, dessen Emitteranschluß mit dem Emitteranschluß des ersten Oszillatortransistors (T1) gekoppelt ist und dessen Kollektoranschluß mit dem frequenzbestimmenden Element (L, C) des Oszillators verbunden ist, und daß die aus einer Amplitudenänderung des am Basisanschluß mindestens eines der Oszillatortransistoren anliegenden Signals resultierende Gleichspannungsänderung am Emitteranschluß der Oszillatortransistoren als Steuergröße für den Strom der steuerbaren Stromquelle (IE) verwendet wird.

2. Schaltungsanordnung nach Anspruch 1,
**dadurch gekennzeichnet**, daß
der Regelverstärker (A1) einen Anschluß für ein Referenzpotential (UREF) aufweist und daß das Referenzpotential (UREF) mit dem Gleichsignalanteil des am Basisanschluß eines der ersten und zweiten Oszillatortransistoren (T1, T2) anliegenden Signals in fester Beziehung steht.

3. Schaltungsanordnung nach Anspruch 2,
**dadurch gekennzeichnet**, daß
der Emitteranschluß des ersten Oszillatortransistors (T1) über eine Kapazität mit dem Anschluß für das Versorgungspotential (Masse) verbunden ist.

## Claims

1. Circuit arrangement for regulating the amplitude of the output signal of an oscillator having the features:
- the emitter of a first oscillator transistor (T1) is connected via a controllable current source (IE) to a connection for a supply potential (earth),
- the oscillator contains at least one frequency-determining element (L, C) which is connected to the base connection of the first oscillator transistor (T1),
- the emitter connection of the first oscillator transistor (T1) is fed back via a regulating amplifier (A1) to a control input of the controllable current source (IE),
characterized in that a second oscillator transistor (T2) is provided whose emitter connection is coupled to the emitter connection of the first oscillator transistor (T1) and whose collector connection is connected to the frequency-determining element (L, C) of the oscillator, and in that the DC voltage change which results from an amplitude change in the signal applied to the base connection of at least one of the oscillator transistors is used at the emitter connection of the oscillator transistors as the control variable for the current of the controllable current source (IE).

2. Circuit arrangement according to Claim 1, characterized in that the regulating amplifier (A1) has a connection for a reference potential (UREF), and in that the reference potential (UREF) has a fixed relationship with the DC signal element of the signal which is applied to the base connection of one of the first and second oscillator transistors (T1, T2).

3. Circuit arrangement according to Claim 2, characterized in that the emitter connection of the first oscillator transistor (T1) is connected via a capacitance to the connection for the supply potential (earth).

## Revendications

1. Montage de régulation de l'amplitude du signal de sortie d'un oscillateur, ayant les caractéristiques :
- l'émetteur d'un premier transistor (T1) oscillateur est relié par l'intermédiaire d'une source commandable (IE) de courant à une borne d'un potentiel d'alimentation (masse),
- l'oscillateur comprend au moins un élément (L, C) qui détermine la fréquence et est connecté à la borne de base du premier transistor (T1) oscillateur,
- la borne d'émetteur du premier transistor (T1) oscillateur est couplée en rétroaction par l'intermédiaire d'un amplificateur (A1) de régulation à une entrée de commande de la source commandable (IE) de courant,
caractérisé en ce que
- il est prévu un deuxième transistor (T2) oscillateur, dont la borne d'émetteur est couplée à la borne d'émetteur du premier transistor (T1) oscillateur et dont la borne de collecteur est reliée à l'élément (L, C) oscillateur, qui détermine la fréquence, et la variation de tension continue à la borne d'émetteur des transistors oscillateurs, qui résulte d'une variation d'amplitude du signal appliqué à la borne de base d'au moins l'un des transistors oscillateurs, est utilisée comme grandeur de commande pour le courant de la source commandable (IE) de courant.

2. Montage suivant la revendication 1, caractérisé en ce que l'amplificateur (A1) de régulation comporte une borne pour un potentiel (UREF) de référence et le potentiel (UREF) de référence est en relation fixe avec la composante de signal continu du signal appliqué à la borne de base de l'un des premier et deuxième transistors oscillateurs (T1,T2).

3. Montage suivant la revendication 2, caractérisé en ce que la borne d'émetteur du premier transistor oscillateur (T1) est reliée par l'intermédiaire d'une capacité à la borne du potentiel d'alimentation (masse).
